# EUROPEAN PATENT APPLICATION

(11) **EP 3 940 791 A1**
(43) Date of publication of application: **19.01.2022**
(21) Application number: 20769844.0
(22) Date of filing: 24.01.2020
(51) Int. Cl.: H01L 29/78, H01L 21/336, H01L 21/8234, H01L 27/06, H01L 27/088, H01L 27/146

(54) **SEMICONDUCTOR ELEMENT, SEMICONDUCTOR DEVICE, METHOD OF MANUFACTURING SEMICONDUCTOR ELEMENT, AND METHOD OF MANUFACTURING SEMICONDUCTOR DEVICE**

(30) Priority: 14.03.2019 JP 2019047655
(71) Applicant: Sony Semiconductor Solutions Corporation, Atsugi-shi Kanagawa 243-0014 (JP)
(72) Inventor: KIMIZUKA, Naohiko, Atsugi-shi, Kanagawa 243-0014 (JP); KATAOKA, Toyotaka, Atsugi-shi, Kanagawa 243-0014 (JP); KUDOH, Yoshiharu, Atsugi-shi, Kanagawa 243-0014 (JP)
(74) Representative: MFG Patentanwälte Meyer-Wildhagen Meggle-Freund Gerhard PartG mbB
(86) International application number: PCT/JP2020/002508
(87) International publication number: WO 2020/183937

(57) **Abstract**

Provided is a semiconductor device capable of further improving the performance of a semiconductor element having a gate electrode surrounding three surfaces of a plate-shaped channel region. The semiconductor device includes a semiconductor layer, a channel region, first and second main electrode regions, a gate insulating film, and a gate electrode. The channel region is disposed in the upper part of the semiconductor layer. The first and second main electrode regions are opposed to each other and disposed on the opposing ends in the channel length direction of the channel region. The gate insulating film is disposed on the inner walls of first and second trenches and on the upper surface of the channel region. The first and second trenches are disposed on both lateral surfaces that are opposed to each other in the channel region. The gate electrode includes a first protruding section, a second protruding section, and a horizontal section. The first protruding section is embedded in the first trench through the gate insulating film. The second protruding section is embedded in the second trench through the gate insulating film. The horizontal section is connected to the upper ends of the first and second protruding sections and disposed on the upper surface of the channel region through the gate insulating film. The depth of the first and second main electrode regions is equal to or greater than the depth of the first and second protruding sections.

## Description

### [Technical Field]

A technology according to the present disclosure (the present technology) relates to a semiconductor element, a semiconductor device, a semiconductor element manufacturing method, and a semiconductor device manufacturing method.

### [Background Art]

Proposed in the past are MOSFETs (fin FETs) that are configured for such improvement as noise immunity improvement, by surrounding three main surfaces of a plate-shaped channel region with a gate electrode including a protruding section embedded in the upper part of a semiconductor layer (refer, for example, to PTL 1 and PTL 2).

### [Citation List]

### [Patent Literature]

[PTL 1]
   Japanese Patent Laid-open No. 2006-121093
[PTL 2]
   Japanese Patent Laid-open No. 2006-121093

### [Summary]

### [Technical Problem]

The fin FETs described in PTL 1 and PTL 2 need further performance improvement such as the improvement of transconductance gm. PTL 1 and PTL 2 do not describe any relation between the depth of the protruding section included in the gate electrode of a MOSFET and the depth of the source and drain regions.

An object of the present technology is to provide a semiconductor element, a semiconductor device, a semiconductor element manufacturing method, and a semiconductor device manufacturing method that make it possible to further improve the performance of an insulated-gate semiconductor element having a gate electrode surrounding the three surfaces of the plate-shaped channel region.

### [Solution to Problem]

According to one aspect of the present technology, there is provided a semiconductor element including a semiconductor layer, a channel region, first and second main electrode regions, a gate insulating film, and a gate electrode. The channel region is disposed in an upper part of the semiconductor layer. The first and second main electrode regions are opposed to each other and disposed on opposing ends in a channel length direction of the channel region. The gate insulating film is disposed on inner walls of first and second trenches and on an upper surface of the channel region. The first and second trenches are disposed on both lateral surfaces that are opposed to each other in a channel width direction of the channel region. The gate electrode includes a first protruding section, a second protruding section, and a horizontal section. The first protruding section is embedded in the first trench through the gate insulating film. The second protruding section is embedded in the second trench through the gate insulating film. The horizontal section is connected to upper ends of the first and second protruding sections and disposed on the upper surface of the channel region through the gate insulating film. The first and second main electrode regions have the same depth as the first and second protruding sections including the gate insulating film.

According to another aspect of the present technology, there is provided a semiconductor device including a first semiconductor element and a second semiconductor element. The first semiconductor element includes a semiconductor layer, a channel region, first and second main electrode regions, a gate insulating film, and a gate electrode. The channel region is disposed in an upper part of the semiconductor layer. The first and second main electrode regions are opposed to each other and disposed on opposing ends in a channel length direction of the channel region. The gate insulating film is disposed on inner walls of first and second trenches and on an upper surface of the channel region. The first and second trenches are disposed on both lateral surfaces that are opposed to each other in a channel width direction of the channel region. The gate electrode includes a first protruding section, a second protruding section, and a horizontal section. The first protruding section is embedded in the first trench through the gate insulating film. The second protruding section is embedded in the second trench through the gate insulating film. The horizontal section is connected to upper ends of the first and second protruding sections and disposed on the upper surface of the channel region through the gate insulating film. The second semiconductor element includes third and fourth main electrode regions and a second gate electrode. The third and fourth main electrode regions are opposed to each other and disposed in the upper part of the semiconductor layer. The second gate electrode is disposed on a semiconductor layer sandwiched between the third and fourth main electrode regions through a second gate insulating film. The first and second main electrode regions have the same depth as the first and second protruding sections including the gate insulating film.

According to yet another aspect of the present technology, there is provided a semiconductor element manufacturing method including the steps of digging a recessed section in an upper part of a semiconductor layer so as to form a channel region demarcated by the recessed section; embedding an element separation insulating film in the recessed section; forming a channel region in the upper part of the semiconductor layer; embedding an element separation insulating film in the upper part of the semiconductor layer; selectively removing the element separation insulating film and digging first and second trenches so as to expose lateral surfaces that are opposed to each other in a channel width direction of the channel region; forming a gate insulating film on inner walls of the first and second trenches and on an upper surface of the channel region; embedding a conductive material layer in the first and second trenches through the gate insulating film and forming a gate electrode including a first protruding section, a second protruding section, and a horizontal section, the first protruding section being embedded in the first trench, the second protruding section being embedded in the second trench, the horizontal section being connected to upper ends of the first and second protruding sections and disposed on the upper surface of the channel region through the gate insulating film; and forming first and second main electrode regions that are opposed to each other across opposing ends in a channel length direction of the channel region and have the same depth as the first and second protruding sections including the gate insulating film.

According to still another aspect of the present technology, there is provided a semiconductor device manufacturing method including the steps of digging a recessed section in an upper part of a semiconductor layer so as to form a channel region demarcated by the recessed section; embedding an element separation insulating film in the recessed section; selectively removing the element separation insulating film and digging first and second trenches so as to expose lateral surfaces that are opposed to each other in the channel width direction of the channel region; forming a gate insulating film on inner walls of the first and second trenches and on an upper surface of the channel region; embedding a conductive material layer in the first and second trenches through the gate insulating film and forming a gate electrode including a first protruding section, a second protruding section, and a horizontal section, the first protruding section being embedded in the first trench, the second protruding section being embedded in the second trench, the horizontal section being connected to upper ends of the first and second protruding sections and disposed on the upper surface of the channel region through the gate insulating film; forming first and second main electrode regions that are opposed to each other across opposing ends in a channel length direction of the channel region and have the same depth as the first and second protruding sections including the gate insulating film; forming a second gate electrode on the semiconductor layer through the gate insulating film; and forming third and fourth main electrode regions that are opposed to each other across the semiconductor layer below the second gate electrode and differ in depth from the first and second main electrode regions.

### [Brief Description of Drawings]

[FIG. 1]

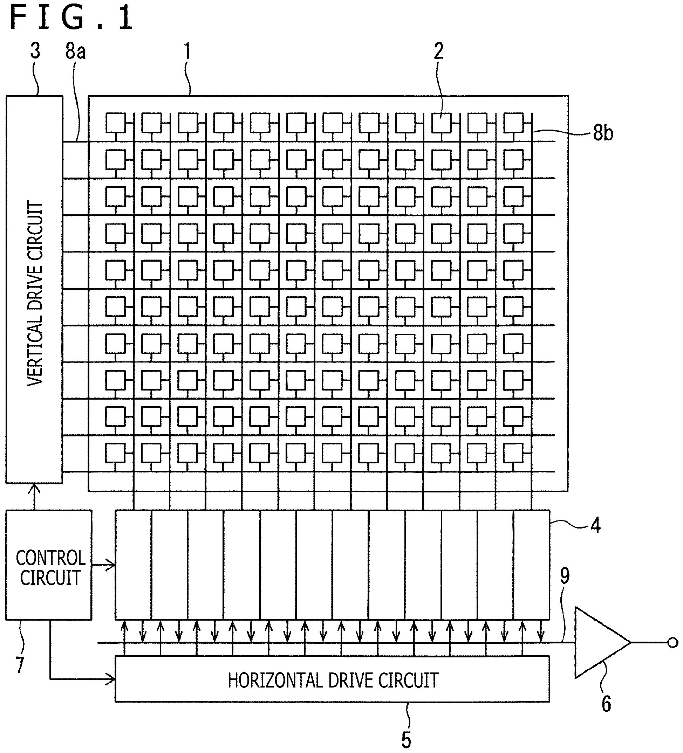

   FIG. 1 is a schematic diagram illustrating a configuration of a semiconductor device (solid-state imaging device) according to a first embodiment.
[FIG. 2]

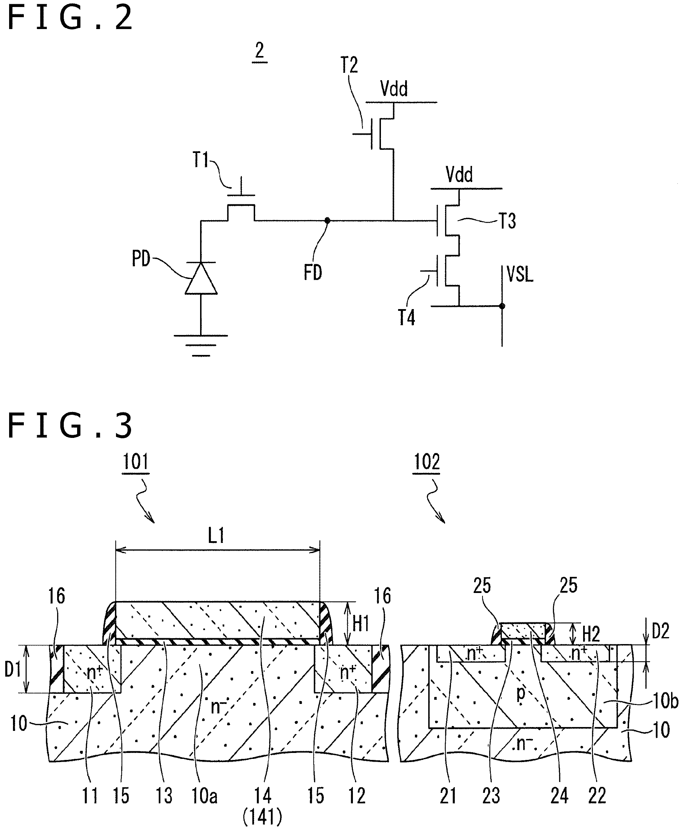

   FIG. 2 illustrates an equivalent circuit of a pixel region of the semiconductor device according to the first embodiment.
[FIG. 3]
   FIG. 3 is a cross-sectional view of essential parts of the semiconductor device according to the first embodiment.
[FIG. 4]

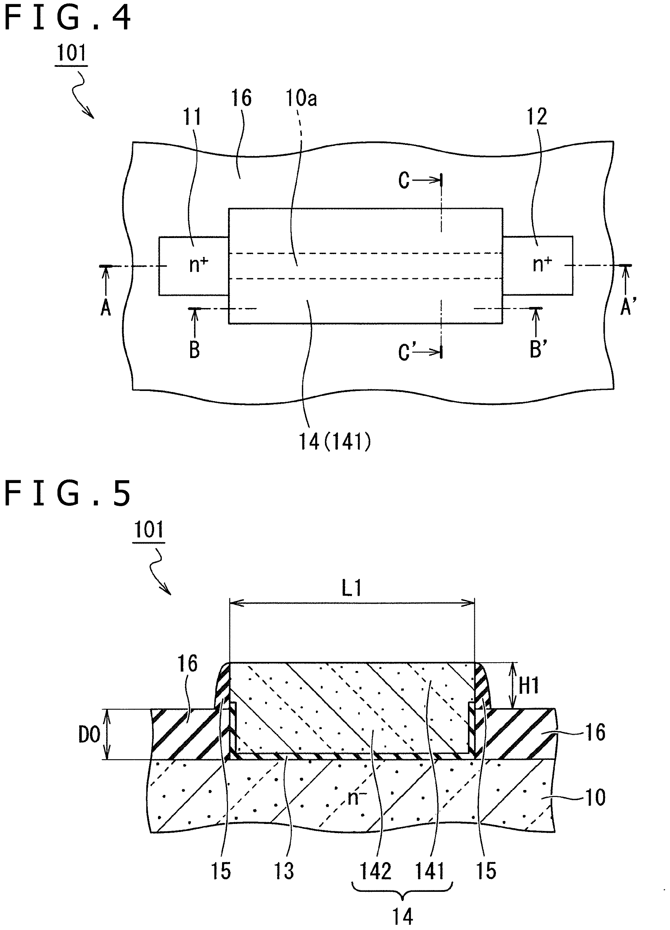

   FIG. 4 is a plan view of essential parts of the semiconductor device according to the first embodiment.
[FIG. 5]
   FIG. 5 is a cross-sectional view of plane B-B' of FIG. 4.
[FIG. 6]

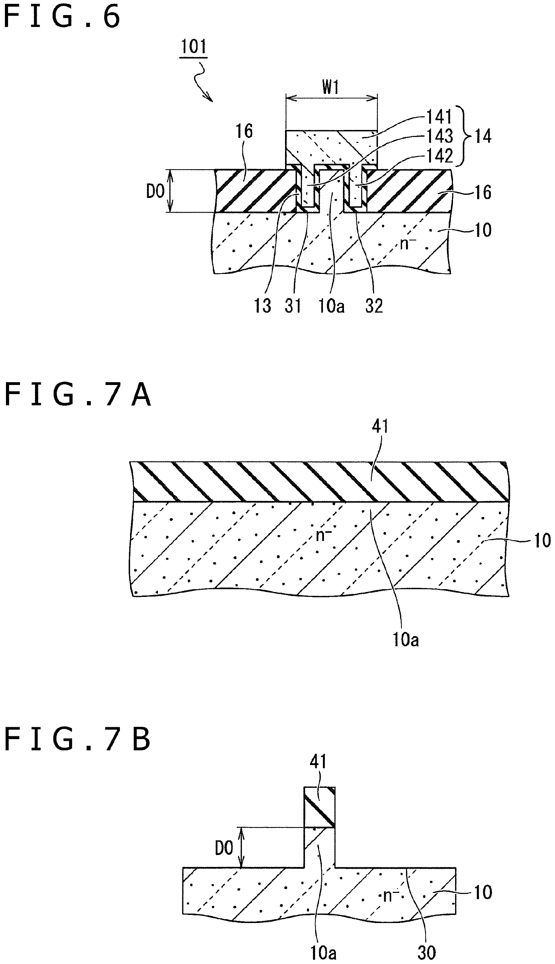

   FIG. 6 is a cross-sectional view of plane C-C' of FIG. 4.
[FIG. 7A]
   FIG. 7A is a cross-sectional view illustrating a process of a manufacturing method for the semiconductor device according to the first embodiment.
[FIG. 7B]
   FIG. 7B is a cross-sectional view illustrating a process of the manufacturing method for the semiconductor device according to the first embodiment.
[FIG. 8A]

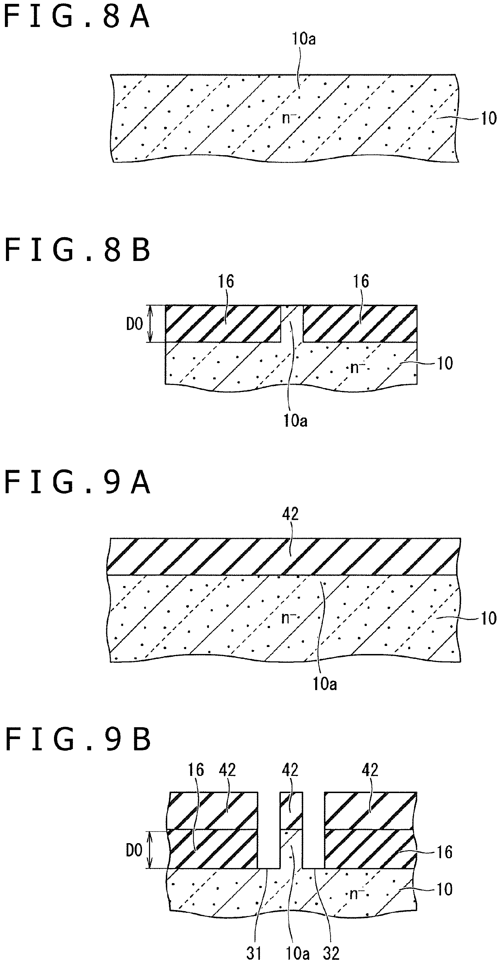

   FIG. 8A is a cross-sectional view illustrating a process of the manufacturing method for the semiconductor device according to the first embodiment that is performed subsequently to the process depicted in FIG. 7A.
[FIG. 8B]
   FIG. 8B is a cross-sectional view illustrating a process of the manufacturing method for the semiconductor device according to the first embodiment that is performed subsequently to the process depicted in FIG. 7B.
[FIG. 9A]
   FIG. 9A is a cross-sectional view illustrating a process of the manufacturing method for the semiconductor device according to the first embodiment that is performed subsequently to the process depicted in FIG. 8A.
[FIG. 9B]
   FIG. 9B is a cross-sectional view illustrating a process of the manufacturing method for the semiconductor device according to the first embodiment that is performed subsequently to the process depicted in FIG. 8B.
[FIG. 10A]

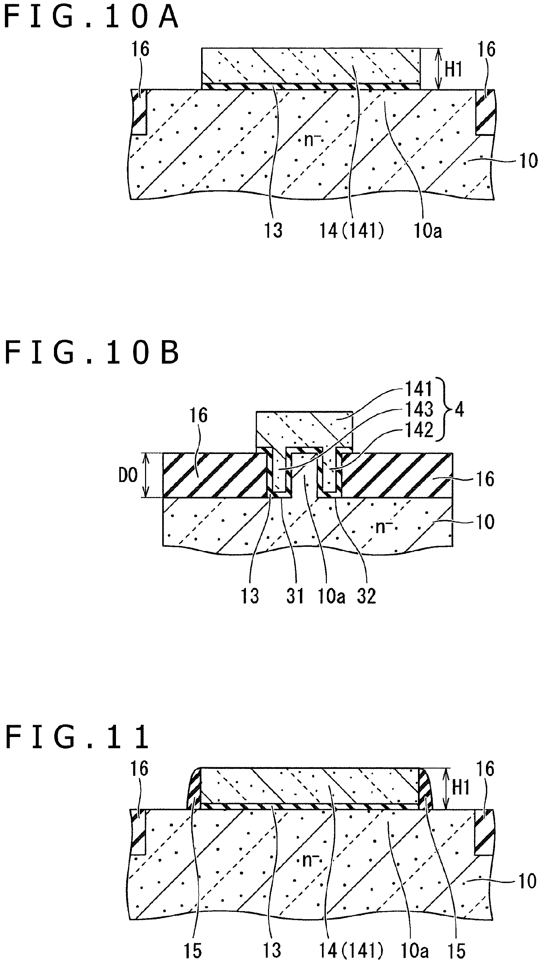

   FIG. 10A is a cross-sectional view illustrating a process of the manufacturing method for the semiconductor device according to the first embodiment that is performed subsequently to the process depicted in FIG. 9A.
[FIG. 10B]
   FIG. 10B is a cross-sectional view illustrating a process of the manufacturing method for the semiconductor device according to the first embodiment that is performed subsequently to the process depicted in FIG. 9B.
[FIG. 11]
   FIG. 11 is a cross-sectional view illustrating a process of the manufacturing method for the semiconductor device according to the first embodiment that is performed subsequently to the process depicted in FIG. 10.
[FIG. 12]

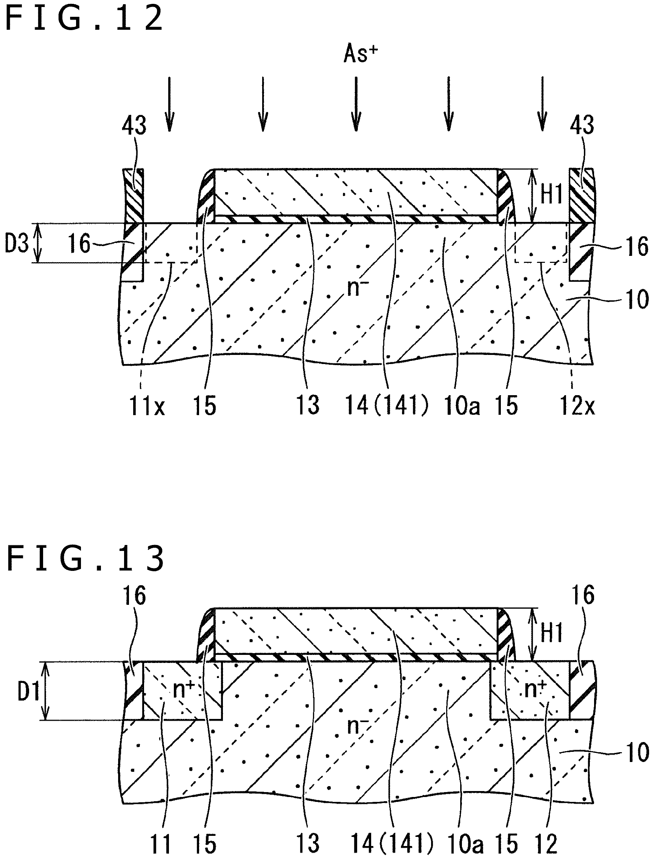

   FIG. 12 is a cross-sectional view illustrating a process of the manufacturing method for the semiconductor device according to the first embodiment that is performed subsequently to the process depicted in FIG. 11.
[FIG. 13]
   FIG. 13 is a cross-sectional view illustrating a process of the manufacturing method for the semiconductor device according to the first embodiment that is performed subsequently to the process depicted in FIG. 12.
[FIG. 14]

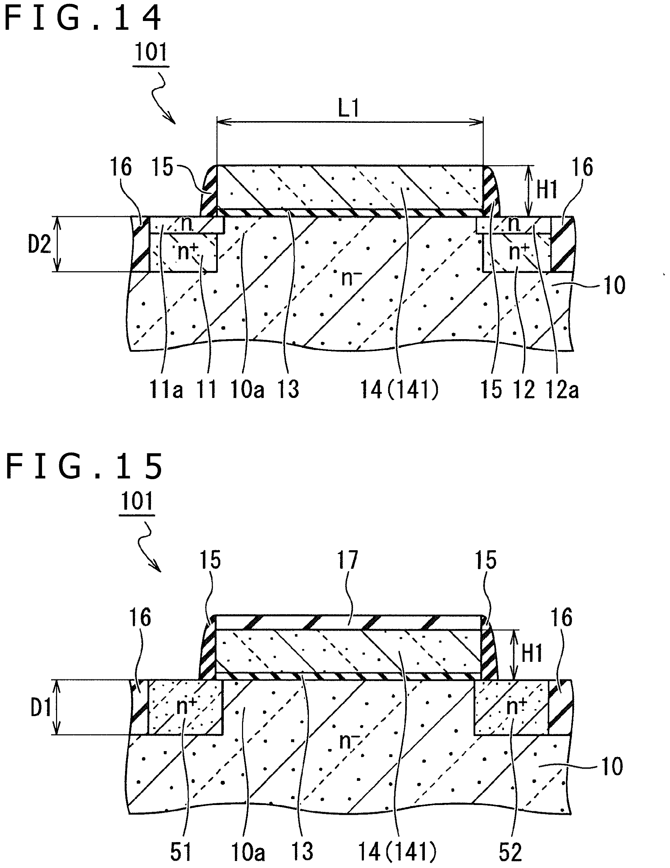

   FIG. 14 is a cross-sectional view of essential parts of the semiconductor device according to a modification of the first embodiment.
[FIG. 15]
   FIG. 15 is a cross-sectional view of essential parts of the semiconductor device according to a second embodiment.
[FIG. 16]

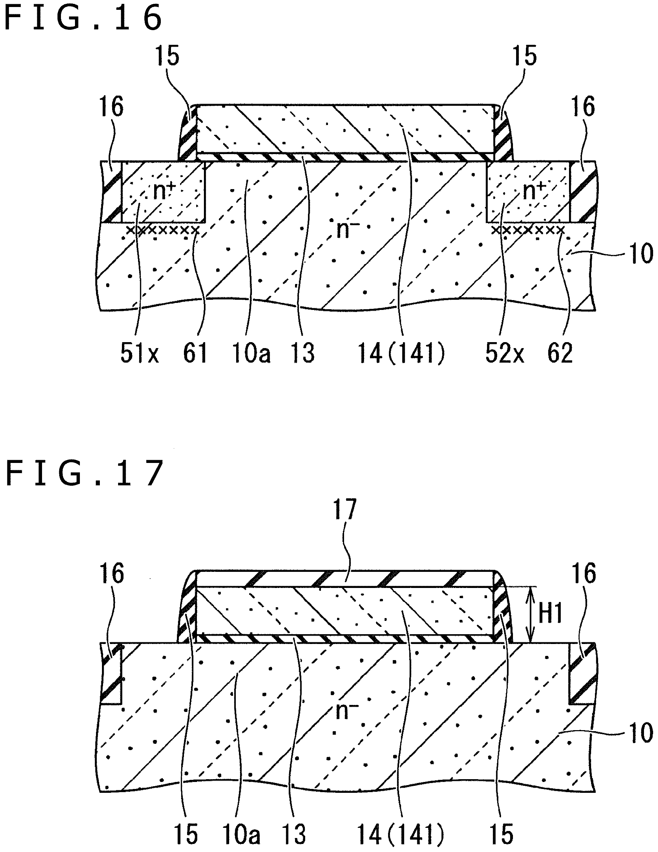

   FIG. 16 is a cross-sectional view of essential parts of the semiconductor device according to a comparative example of the second embodiment.
[FIG. 17]
   FIG. 17 is a cross-sectional view illustrating a process of the manufacturing method for the semiconductor device according to the second embodiment.
[FIG. 18]

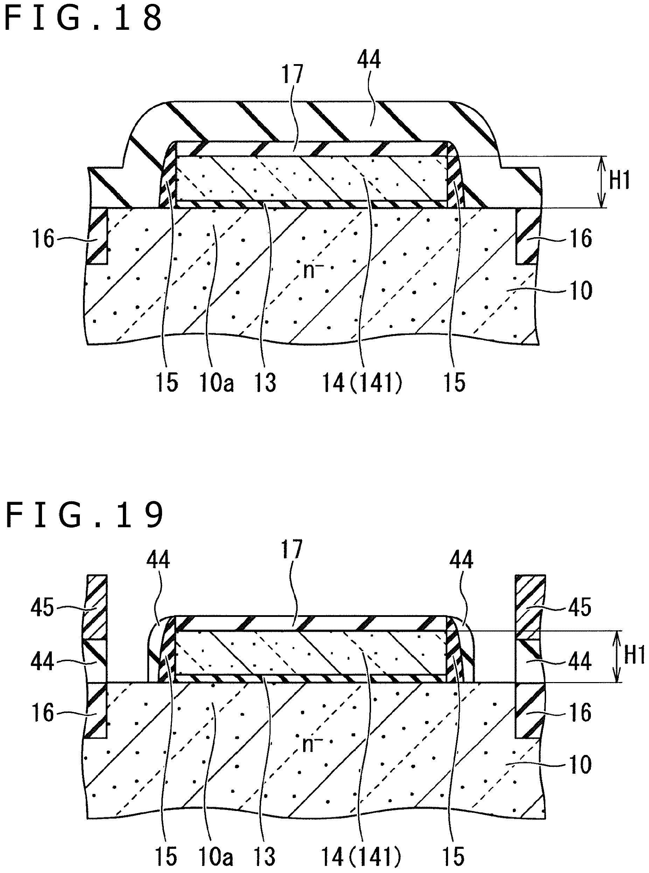

   FIG. 18 is a cross-sectional view illustrating a process of the manufacturing method for the semiconductor device according to the second embodiment that is performed subsequently to the process depicted in FIG. 17.
[FIG. 19]
   FIG. 19 is a cross-sectional view illustrating a process of the manufacturing method for the semiconductor device according to the second embodiment that is performed subsequently to the process depicted in FIG. 18.
[FIG. 20]

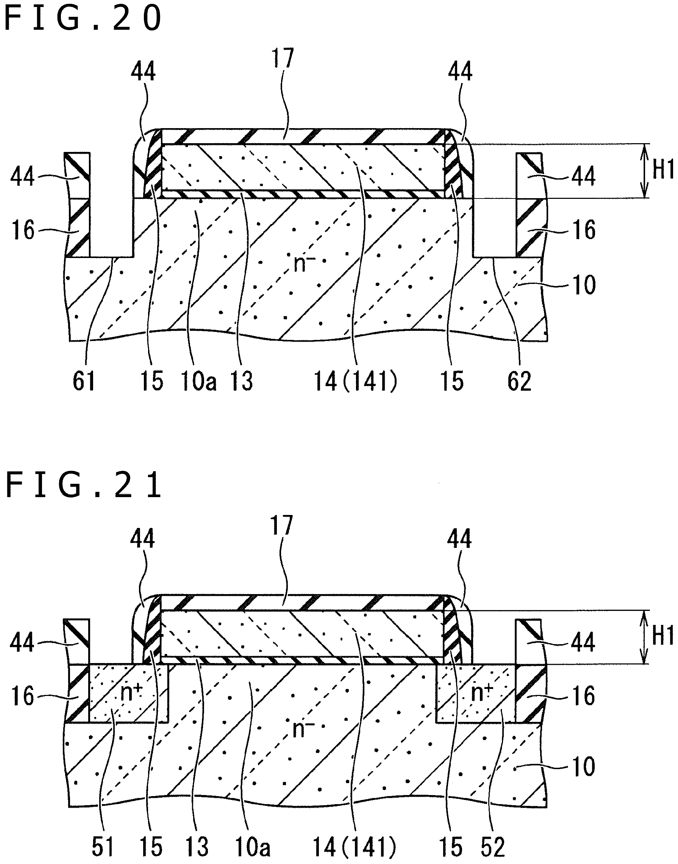

   FIG. 20 is a cross-sectional view illustrating a process of the manufacturing method for the semiconductor device according to the second embodiment that is performed subsequently to the process depicted in FIG. 19.
[FIG. 21]
   FIG. 21 is a cross-sectional view illustrating a process of the manufacturing method for the semiconductor device according to the second embodiment that is performed subsequently to the process depicted in FIG. 20.
[FIG. 22]

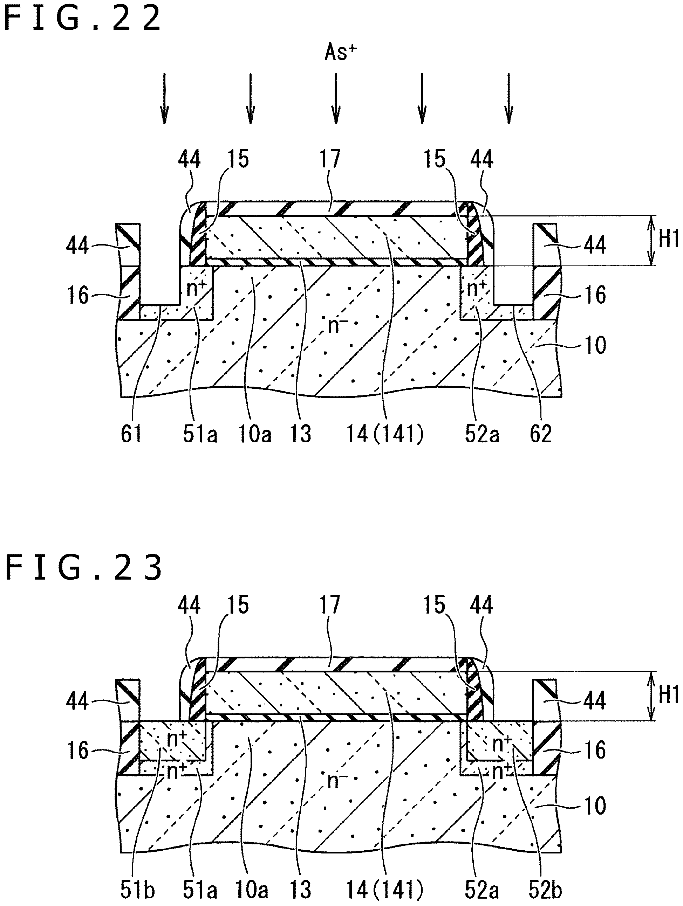

   FIG. 22 is a cross-sectional view illustrating a process of the manufacturing method for the semiconductor device according to the second embodiment that is performed subsequently to the process depicted in FIG. 21.
[FIG. 23]
   FIG. 23 is a cross-sectional view illustrating a process of the manufacturing method for the semiconductor device according to a modification of the second embodiment.
[FIG. 24]

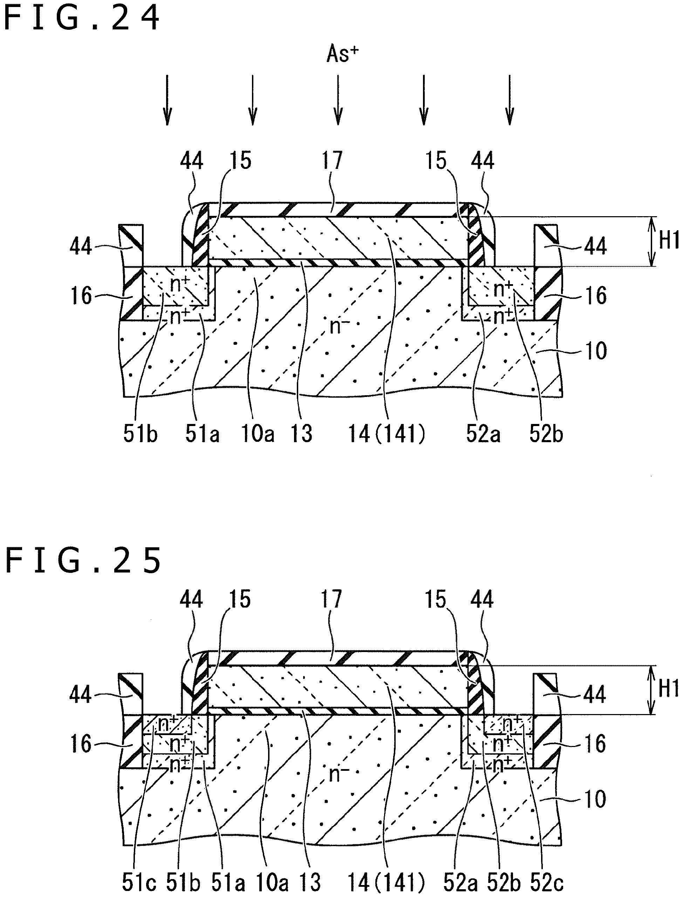

   FIG. 24 is a cross-sectional view illustrating a process of the manufacturing method for the semiconductor device according to the modification of the second embodiment that is performed subsequently to the process depicted in FIG. 23.
[FIG. 25]
   FIG. 25 is a cross-sectional view illustrating a process of the manufacturing method for the semiconductor device according to the modification of the second embodiment that is performed subsequently to the process depicted in FIG. 24.
[FIG. 26]

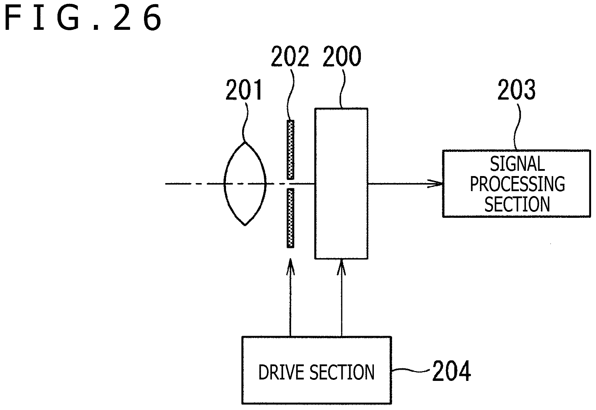

   FIG. 26 is a schematic diagram illustrating electronic equipment to which the semiconductor device according to an alternative embodiment is applied.

### [Description of Embodiments]

First and second embodiments of the present technology will now be described with reference to the accompanying drawings. In the drawings referred to in the following description, components identical or similar to each other are designated by identical or similar reference signs. However, it is well to remember that the drawings are schematic, and that, for example, the relation between thicknesses and planar dimensions and the ratio between individual layer thicknesses are different from actual ones. Thus, specific thicknesses and dimensions should be determined based on the subsequent description. Further, it is obvious that the individual drawings may differ from each other in dimensional relation or ratio. It should be noted that advantages described in the present specification are merely illustrative and not restrictive, and that the present technology may provide additional advantages.

In the present specification, a "first main electrode region" of a semiconductor element included in a semiconductor device, such as a solid-state imaging device, denotes a semiconductor region acting as a source or drain region of, for example, an insulated-gate field-effect transistor (MISFET), an insulated-gate static induction transistor (MISSIT), or a high-electron-mobility transistor (HEMT). A "second main electrode region" denotes a semiconductor region acting as a source or drain region other than the first main electrode region of, for example, the MISFET. As described above, when the "first main electrode region" is a source region, the "second main electrode region" denotes a drain region. Further, a "third main electrode region" and a "fourth main electrode region" of the semiconductor element included in the semiconductor device, such as a solid-state imaging device, have the same relation as that between the "first main electrode region" and the "second main electrode region."

Further, the following description is illustrative of a case where a first conductivity type is an n type and a second conductivity type is a p type. Alternatively, however, the above-mentioned conductivity relation may be reversed to regard the first conductivity type as the p type and the second conductivity type as the n type. Moreover, the "+" and "-" signs attached to "n" and "p" respectively represent a semiconductor region having a relatively high impurity concentration and a semiconductor region having a relatively low impurity concentration as compared to a semiconductor region to which the "+" or "-" sign is not attached. However, even when the same "n" is attached to two or more semiconductor regions, it does not signify that such semiconductor regions have exactly the same impurity concentration.

Additionally, definitions of upward, downward, and other directions mentioned in the subsequent description are merely formulated for convenience of explanation, and not intended to limit the technical idea of the present technology. For example, it is obvious that, when a target is rotated 90 degrees and observed, the up-down direction is read as a left-right direction, and when the target is rotated 180 degrees and observed, the up-down direction is read as a reversed up-down direction.

### (First Embodiment)

### <Semiconductor Device>

A solid-state imaging device, such as a CMOS image sensor, is described here as an example of a semiconductor device (semiconductor integrated circuit) according to a first embodiment. As depicted in FIG. 1, the semiconductor device according to the first embodiment includes a pixel region 1 and peripheral circuits (3, 4, 5, 6, and 7). The pixel region 1 includes plural pixels 2 that are arranged in a two-dimensional matrix. Although not depicted in FIG. 1, the plural pixels 2 each include a photoelectric conversion section and plural pixel transistors. The photoelectric conversion section photoelectrically converts incident light. The plural pixel transistors control a photoelectrically converted signal charge. Four transistors, such as a transfer transistor, a reset transistor, a select transistor, and an amplifying transistor, may be adopted as the plural pixel transistors.

The peripheral circuits (3, 4, 5, 6, and 7) include a vertical drive circuit 3, column signal processing circuits 4, a horizontal drive circuit 5, an output circuit 6, and a control circuit 7. The vertical drive circuit 3 includes, for example, a shift register. The vertical drive circuit 3 sequentially selects pixel drive wirings 8a, supplies a pulse for driving the pixels 2 to the selected pixel drive wirings 8a, and drives the individual pixels 2 on an individual row basis. More specifically, the vertical drive circuit 3 selectively and sequentially scans, in the vertical direction, each pixel 2 in the pixel region 1 on an individual row basis, and supplies an output signal (pixel signal) from each pixel 2 that is based on the signal charge generated by the photoelectric conversion section of each pixel 2 to the column signal processing circuits 4 through vertical signal lines 8b.

The column signal processing circuits 4 are each disposed, for example, for each column of the pixels 2 and configured to perform signal processing, such as a noise removal process, on signals outputted from the pixels 2 in one row, on an individual pixel column basis. For example, the column signal processing circuits 4 each perform signal processing, such as analog-to-digital conversion (AD) and correlated double sampling (CDS) for removing pixel-specific, fixed pattern noise.

The horizontal drive circuit 5 includes, for example, a shift register. The horizontal drive circuit 5 sequentially outputs a horizontal scanning pulse to the column signal processing circuits 4, selects the column signal processing circuits 4 in a sequential order, and causes the selected column signal processing circuits 4 to output signal-processed pixel signals to the horizontal signal line 9. The output circuit 6 performs signal processing on the pixel signals sequentially supplied from the individual column signal processing circuits 4 through the horizontal signal line 9, and outputs the signal-processed pixel signals.

Based on a vertical synchronization signal, a horizontal synchronization signal, and a master clock signal, the control circuit 7 generates clock signals and control signals that act as operating standards for, for example, the vertical drive circuit 3, the column signal processing circuits 4, and the horizontal drive circuit 5. Then, the control circuit 7 outputs the generated clock signals and control signals to, for example, the vertical drive circuit 3, the column signal processing circuits 4, and the horizontal drive circuit 5.

The semiconductor device according to the first embodiment may include a single substrate on which the components depicted in FIG. 1 are mounted or may have a layered structure in which plural substrates are attached to each other. For example, the semiconductor device according to the first embodiment may include first and second substrates, dispose the photoelectric conversion sections and the pixel transistors on the first substrate, and dispose, for example, the peripheral circuits (3, 4, 5, 6, and 7) on the second substrate. An alternative configuration may be adopted in such a manner that the photoelectric conversion sections and some of the pixel transistors are disposed on the first substrate while the remaining pixel transistors and the peripheral circuits (3, 4, 5, 6, and 7) are disposed on the second substrate.

FIG. 2 illustrates an example of an equivalent circuit of a pixel 2 in the semiconductor device according to the first embodiment. As depicted in FIG. 2, the anode of a photodiode PD acting as the photoelectric conversion section of the pixel 2 is grounded, and the cathode of the photodiode PD is connected to the source of a transfer transistor T1 functioning as an active element. The drain of the transfer transistor T1 is connected to a charge storage region (floating diffusion region) FD in a floating state. The charge storage region FD is connected to the source of a reset transistor T2 functioning as an active element, and connected to the gate of an amplifying transistor T3 functioning as an active element. The source of the amplifying transistor T3 is connected to the drain of a select transistor T4 functioning as an active element, and the drain of the amplifying transistor T3 is connected to a power supply Vdd. The source of the select transistor T4 is connected to a vertical signal line VSL. The drain of the reset transistor T2 is connected to the power supply Vdd.

When the semiconductor device according to the first embodiment is operating, the signal charge generated by the photodiode Pd of the pixel 2 is stored in the charge storage region FD of the pixel 2 through the transfer transistor T1 of the pixel 2. The signal charge stored in the charge storage region FD of the pixel 2 is then read and applied to the gate of the amplifying transistor T3 of the pixel 2. A horizontal line selection control signal is given from a vertical shift register to the gate of the select transistor T4 of the pixel 2. When the selection control signal goes high (H), the select transistor T4 conducts, so that a current corresponding to the potential of the charge storage region FD of the pixel 2 that is amplified by the amplifying transistor T3 of the pixel 2 flows to the vertical signal line VSL. Further, when a reset control signal to be applied to the gate of the reset transistor T2 goes high (H), the reset transistor T2 of the pixel 2 conducts to reset the signal charge stored in the charge storage region FD of the pixel 2.

As depicted in FIG. 3, the semiconductor device according to the first embodiment includes a first semiconductor element 101 and a second semiconductor element 102. The first semiconductor element 101 and the second semiconductor element 102 are disposed on the same semiconductor layer (semiconductor substrate) 10. The first semiconductor element 101 is an active element corresponding to, for example, the amplifying transistor T3 depicted in FIG. 2, and is defined as an element in an active region (first active region) of the semiconductor layer 10. The second semiconductor element 102 is an active element corresponding to, for example, a low-voltage analog transistor included in the peripheral circuits (3, 4, 5, 6, and 7) depicted in FIG. 1, and is defined as an element in an active region (second active region) of the semiconductor layer 10.

FIG. 4 is a plan view of the first semiconductor element 101 depicted on the left side of FIG. 3, which is equivalent to a cross-sectional view of plane A-A' of FIG. 4. FIG. 5 is a cross-sectional view of plane B-B' of FIG. 4. FIG. 6 is a cross-sectional view of plane C-C' of FIG. 4. It should be noted that, for the sake of convenience, FIGS. 3 to 6 do not depict the coverings for the first and second semiconductor elements 101 and 102, such as interlayer insulating films, gate surface wirings, source electrodes, drain electrodes, and protective films.

As depicted in FIGS. 3 to 6, the first semiconductor element 101 includes a first main electrode region (source region) 11 of a first conductivity type (n⁺ type) and a second main electrode region (drain region) 12 of the first conductivity type (n⁺ type). The first main electrode region 11 and the second main electrode region 12 are positioned toward the opposing ends in the direction of the channel length L of a channel region 10a and disposed in the upper part of the semiconductor layer 10 so as to be opposed to each other.

The semiconductor layer 10 may include a high-resistivity silicon (Si) substrate of the first conductivity type (n⁻ type) and used in a depleted state. Further, the semiconductor layer 10 may be a well region in the upper part of the Si substrate or an epitaxial growth layer on the Si substrate. Alternatively, the semiconductor layer 10 may include a semiconductor layer on an insulating layer included in an SOI substrate. Yet alternatively, the semiconductor layer 10 may be formed by a Si substrate of a second conductivity type (p⁻ type).

The first and second main electrode regions 11 and 12 have a higher impurity concentration than the semiconductor layer 10. The depth D1 of the first and second main electrode regions 11 and 12, which is defined in FIG. 3, is, for example, approximately 200 to 500 nm, and may be, for example, approximately 300 nm. The first and second main electrode regions 11 and 12 are demarcated and element-separated by an element separation insulating film 16 that is provided on an upper part of the semiconductor layer 10. The element separation insulating film 16 can be formed by an insulating film such as a silicon oxide film (SiO₂ film).

As depicted in FIGS. 3, 4, and 6, the channel region (first channel region) 10a is formed by a part of the semiconductor layer 10 sandwiched between the first and second main electrode regions 11 and 12. The first channel region 10a is configured as a fin type (plate-shaped), and extended in a direction (the direction of the channel length L1) in which the first and second main electrode regions 11 and 12 are opposed to each other. FIG. 4 uses broken lines to schematically depict the first channel region 10a, which is hidden underneath a gate electrode (first gate electrode) 14.

As depicted in FIGS. 3 to 6, the first semiconductor element 101 includes the first gate electrode 14. The first gate electrode 14 is disposed so as to surround the upper surface and opposing lateral surfaces of the first channel region 10a through a gate insulating film (first gate insulating film) 13.

The material for the first gate insulating film 13 may be a single-layer film of any one of a silicon oxide film (SiO₂ film), a silicon oxynitride film (SiON film), a strontium oxide film (SrO film), a silicon nitride film (Si₃N₄ film), an aluminum oxide film (Al₂O₃ film), a magnesium oxide film (MgO film), a yttrium oxide film (Y₂O₃ film), a hafnium oxide film (HfO₂ film), a zirconium oxide film (ZrO₂ film), a tantalum oxide film (Ta₂O₅ film), or a bismuth oxide film (Bi₂O₃ film), or may be a composite membrane obtained by stacking the above-mentioned films. In a case where the SiO₂ film is used as the first gate insulating film 13, its thickness may be set to, for example, approximately 5 to 20 nm as far as a low operating voltage is used to avoid a problem caused by a Fowler-Nordheim (FN) tunneling current. In a case where the thickness of the SiO₂ film is 5 nm or less, it is necessary to consider leakage caused by a direct tunneling current. However, the equivalent film thickness of the SiO₂ film can be 1 nm or less when a selected material provides the first gate insulating film 13 with a high relative permittivity.

The material for the first gate electrode 14 may be, for example, polysilicon into which high-concentration n-type impurities are introduced (doped polysilicon). It should be noted that the material for the first gate electrode 14 may be not only the doped polysilicon (DOPOS) but also a conductive material such as tungsten (W), molybdenum (Mo), titanium (Ti), or other high melting point metal, silicide including high melting point metal and polysilicon, or polycide, which is a composite membrane including polysilicon and silicide of high melting point metal.

As depicted in FIGS. 3 to 6, the first gate electrode 14 includes a first protruding section 142, a second protruding section 143, and a horizontal section 141. The first and second protruding sections 142 and 143 are embedded in the upper part of the semiconductor layer 10 through the first gate insulating film 13, and disposed parallel to each other. The horizontal section 141 is disposed on the semiconductor layer 10 through the first gate insulating film 13, and is configured to connect the upper surfaces of the first and second protruding sections 142 and 143. In the first and second protruding sections 142 and 143 and in the horizontal section 141, the first gate electrode 14 is substantially shaped like a C-shaped rail (hereinafter referred to as being "C-rail-shaped"). That is, the first semiconductor element 101 forms a MOSFET (fin FET) having the plate-shaped (fin-shaped) first channel region 10a whose upper and lateral surfaces are surrounded by the C-rail-shaped first gate electrode 14. Further, the C-rail-shaped first gate electrode 14 forms a structure surrounding the three surfaces of the plate-shaped first channel region 10a (shaped like a thin rectangular parallelepiped).

As depicted in FIG. 6, the cross-sectional shape of the C-rail-shaped first gate electrode 14 can be interpreted as being shaped like the Greek letter n. In a direction orthogonal to the direction in which the first and second main electrode regions 11 and 12 are opposed to each other (in the direction of the channel width W1), both lateral surfaces of the first channel region 10a are sandwiched by the first and second protruding sections 142 and 143 through the first gate insulating film 13. Between the first and second main electrode regions 11 and 12, the first and second protruding sections 142 and 143 are extended parallel to the direction of the channel length L1 of the first channel region 10a. As depicted in FIGS. 3 and 5, a side wall insulating film 15 including, for example, a silicon nitride film (Si₃N₄ film) is disposed on a side wall that is the channel end of the horizontal section 141 of the first gate electrode 14.

FIGS. 3 to 6 indicate that the first gate electrode 14 is C-rail-shaped having two protruding sections, namely, the first and second protruding sections 142 and 143. However, the number of protruding sections of the first gate electrode 14 is not limited to any specific number, and the first gate electrode 14 is not limited to be C-rail-shaped. For example, the first gate electrode 14 may have three or more protruding sections, and two or more channel regions may be included as needed to match the number of protruding sections.

The first gate electrode 14 forms a channel on the upper surface and both lateral surfaces of the first channel region 10a by electrostatically controlling, through the first gate insulating film 13, the surface potential of the first channel region 10a that is opposed to the first and second protruding sections 142 and 143 and the horizontal section 141.

The depth D0 of the first and second protruding sections 142 and 143 including the thickness of the first gate insulating film 13, which is defined in FIGS. 5 and 6 and measured from the upper surface of the channel region 10a, is, for example, approximately 200 to 400 nm, and may be, for example, approximately 300 nm. The height H1 of the horizontal section 141 including the thickness of the first gate insulating film 13, which is defined in FIGS. 3 and 5 and measured from the upper surface of the channel region 10a, is, for example, approximately 200 to 400 nm, and may be, for example, approximately 300 nm. The depth D0 of the first and second protruding sections 142 and 143 and the height H1 of the horizontal section 141 may be substantially equal to or different from each other.

In the semiconductor device according to the first embodiment, the depth D1 of the first and second main electrode regions 11 and 12, which is defined in FIG. 3, is set to be equal to or greater than the depth D0 of the first and second protruding sections 142 and 143 including the thickness of the first gate insulating film 13, which is defined in FIGS. 5 and 6. When D1 ≥ D0 holds, it is possible to increase the transconductance gm of the semiconductor device according to the first embodiment. The depth D1 of the first and second main electrode regions 11 and 12 may be greater than the depth D0 of the first and second protruding sections 142 and 143 including the thickness of the first gate insulating film 13 by, for example, approximately 0 to 200 nm, or more specifically, approximately 0 to 100 nm.

However, increasing the depth D1 of the first and second main electrode regions 11 and 12 increases short-channel effects, and thus makes it difficult to control the drain current by the gate voltage. Thus, in a case where a MOSFET or a MISFET is used as the first semiconductor element 101, it is desirable that, in order to inhibit the short-channel effects from being actualized, the depth D1 of the first and second main electrode regions 11 and 12 be set to be substantially equal to the depth D0 of the first and second protruding sections 142 and 143 including the thickness of the first gate insulating film 13. Alternatively, the depth D1 of the first and second main electrode regions 11 and 12, which is defined in FIG. 3, may be set to be substantially equal to the depth of only the first and second protruding sections 142 and 143, which is defined according to the dimensions excluding the thickness of the first gate insulating film 13. Further, in a case where the depth D1 of the first and second main electrode regions 11 and 12 is equal to the depth D0 of the first and second protruding sections 142 and 143 including the thickness of the first gate insulating film 13, the depths D1 and D0 need not always be perfectly equal. In such a case, the depths D1 and D0 are only required to be substantially equal or close to each other as far as the characteristics of the semiconductor device according to the first embodiment remain intact. Further, a difference in the values of depth within the range of manufacturing error is also allowable.

It should be noted that, in a case where a MISSIT or a MOSSIT is used as the first semiconductor element 101, the depth D1 of the first and second main electrode regions 11 and 12 may be greater than the depth D0 of the first and second protruding sections 142 and 143 including the thickness of the first gate insulating film 13, in order to increase the transconductance gm, because a SIT is a semiconductor element positively utilizing the short-channel effects.

Further, in the semiconductor device according to the first embodiment, the height H1 of the horizontal section 141 in the first gate electrode 14 is set to be equal to or greater than the depth D1 of the first and second main electrode regions 11 and 12. For example, the height H1 of the horizontal section 141 in the first gate electrode 14 is substantially equal to the depth D1 of the first and second main electrode regions 11 and 12 (these two values are each, for example, 300 nm). When the first and second main electrode regions 11 and 12 are formed in a manufacturing process for the semiconductor device according to the first embodiment, the horizontal section 141 is used as an ion implantation mask in order to ion-implant impurities in a self-aligned manner. In this case, setting the height H1 of the horizontal section 141 to be equal to or greater than the depth D1 of the first and second main electrode regions 11 and 12 makes it possible to prevent implanted impurity ions from penetrating the horizontal section 141 and reaching the first channel region 10a.

Meanwhile, the second semiconductor element 102 depicted on the right side of FIG. 3 includes a common planar n-channel MOSFET. The second semiconductor element 102 is disposed in a well region 10b of a second conductivity type (p type) that is disposed in the upper part of the semiconductor layer 10. It should be noted that, in a case where the semiconductor layer 10 includes a Si substrate of the second conductivity type (p⁻ type), the second semiconductor element 102 may be disposed in the semiconductor layer 10. The second semiconductor element 102 includes a third main electrode region (source region) 21 of the first conductivity type (n⁺ type) and a fourth main electrode region (drain region) 22 of the first conductivity type (n⁺ type). The third and fourth main electrode regions 21 and 22 are disposed in the upper part of the well region 10b so as to be opposed to each other. The third and fourth main electrode regions 21 and 22 have a higher impurity concentration than the semiconductor layer 10.

The second semiconductor element 102 further includes a second gate electrode 24. The second gate electrode 24 is disposed on a channel region (second channel region) through a second gate insulating film 23. The second channel region is on the upper surface side of the well region 10b, which is sandwiched between the third and fourth main electrode regions 21 and 22. The second gate electrode 24 forms an inversion channel in the second channel region by electrostatically controlling the surface potential of the second channel region through the second gate insulating film 23. A side wall insulating film 25 including, for example, a silicon nitride film (Si₃N₄ film) is disposed on a side wall that is the channel end of the second gate electrode 24.

The third and fourth main electrode regions 21 and 22 of the second semiconductor element 102 are separately formed in an independent process that is different from a process of forming the first and second main electrode regions 11 and 12 in the first semiconductor element 101. The depth D2 of the third and fourth main electrode regions 21 and 22 in the second semiconductor element 102 is set to be different from the depth D1 of the first and second main electrode regions 11 and 12 in the first semiconductor element 101. For example, the depth D2 of the third and fourth main electrode regions 21 and 22 in the second semiconductor element 102 is set to be smaller than the depth D1 of the first and second main electrode regions 11 and 12. The depth D2 of the third and fourth main electrode regions 21 and 22 in the second semiconductor element 102 is, for example, approximately 100 to 200 nm, and may be, for example, approximately 150 nm.

For example, in a case where a transistor in a peripheral circuit is used as the second semiconductor element 102, forming the third and fourth main electrode regions 21 and 22 in the second semiconductor element 102 by a process independent of a process for the first and second main electrode regions 11 and 12 in the first semiconductor element 101 makes it possible to prevent the first semiconductor element 101 from affecting the miniaturization, for example, of the element separation width and gate length of a peripheral circuit even in a case where the first and second main electrode regions 11 and 12 of the first semiconductor element 101 are formed deeply.

The second gate electrode 24 of the second semiconductor element 102 is separately formed in an independent process that is different from a process of forming the first gate electrode 14 of the first semiconductor element 101. The height H2 of the second gate electrode 24 is set to be different from the height H1 of the horizontal section 141 in the first gate electrode 14. For example, the height H2 of the second gate electrode 24 may be set to be smaller than the height H1 of the horizontal section 141 in the first gate electrode 14. The second gate electrode 24 need not be as thick as the first gate electrode 14. The height H2 of the second gate electrode 24 is, for example, approximately 100 to 200 nm, or more specifically, approximately 150 nm.

When the second gate electrode 24 of the second semiconductor element 102 is separately formed in a process independent of a process for the first gate electrode 14 of the first semiconductor element 101 in a case, for example, where a transistor in a peripheral circuit is used as the second semiconductor element 102, the gate length of the second gate electrode 24 in the second semiconductor element 102 can be miniaturized without being affected by the first semiconductor element 101 even if the height H1 of the horizontal section 141 in the first gate electrode 14 is increased.

### <Semiconductor Device Manufacturing Method>

Referring to FIGS. 7A to 13, an example of a method of manufacturing the semiconductor device according to the first embodiment will now be described with focus placed on the structures of semiconductor elements included in the semiconductor device. In the following description, focus is mainly placed on the first semiconductor element 101 depicted on the left side of FIG. 3. FIGS. 7A, 8A, 9A, and 10 to 13 are process cross-sectional views of plane A-A' of FIG. 3. FIGS. 7B, 8B, and 9B are process cross-sectional views of plane C-C' of FIG. 3.

First of all, an etching protective film (first etching protective film) 41, such as an oxide film, is deposited on the semiconductor layer 10. Then, by using a photolithography technique and performing reactive ion etching (RIE) or other dry etching, the first etching protective film 41 is patterned so as to define first and second active regions. As depicted in FIGS. 7A and 7B, RIE or other drying etching is performed by using the patterned first etching protective film 41 as an etching mask in order to dig a recessed section (element separation recessed section) 30 in the upper part of the semiconductor layer 10 in such a manner as to let the first and second active regions remain in the upper part of the semiconductor layer 10. The upper part of the semiconductor layer 10 that is demarcated by the recessed section 30 and exposed as the first active region becomes the first channel region 10a. Subsequently, the first etching protective film 41 is removed.

Next, in accordance with a shallow trench isolation (STI) method, the element separation insulating film 16, such as an oxide film, is embedded in the inside of the recessed section 30 of the semiconductor layer 10 in order to form the element separation insulating film 16 in such a manner as to demarcate the first active region as depicted in FIGS. 8A and 8B.

Next, in accordance with a CVD method or other similar method, a new etching protective film (second etching protective film) 42, such as an oxide film, is deposited on the first channel region 10a and the element separation insulating film 16. Then, by using the photolithography technique and performing dry etching, the second etching protective film 42 is patterned. As depicted in FIGS. 9A and 9B, RIE or other drying etching is performed by using the patterned second etching protective film 42 as an etching mask, in order to dig a pair of trenches, namely, a first trench 31 and a second trench 32, parallel to each other in such a manner as to selectively remove a part of the element separation insulating film 16 and expose both lateral surfaces of the first channel region 10a. The first channel region 10a is demarcated by being surrounded by vertical side walls of the pair of trenches, namely, the first and second trenches 31 and 32. The pair of trenches, namely, the first and second trenches 31 and 32, penetrate the element separation insulating film 16 and expose the upper surface of the semiconductor layer 10 at the base of the element separation insulating film 16. Subsequently, the second etching protective film 42 is removed.

Next, in accordance with a thermal oxidation method (dry oxidation method) or other similar method, an oxide film is formed, as the first gate insulating film 13, on the inner walls of the pair of trenches, namely, the first and second trenches 31 and 32, and on the upper surface of the first channel region 10a. Simultaneously with the process of forming the first gate insulating film 13 of the first semiconductor element 101, the second gate insulating film 23 of the second semiconductor element 102 depicted in FIG. 3 is provided with the same film thickness and formed in the second active region. Further, in the first active region, in accordance with the CVD method or other similar method, a DOPOS layer or other conductive material layer is deposited on the first channel region 10a and the element separation insulating film 16 through the first gate insulating film 13 in such a manner as to fill the pair of trenches, namely, the first and second trenches 31 and 32. Then, some parts of the first gate insulating film 13 and conductive material layer are selectively removed by using the photolithography technique and performing dry etching. As a result, as depicted in FIGS. 10A and 10B, the C-rail-shaped first gate electrode 14 is formed in the first active region by the first and second protruding sections 142 and 143 and the horizontal section 141. The first and second protruding sections 142 and 143 include conductive material layers embedded in the first and second trenches 31 and 32 through the first gate insulating film 13. The horizontal section 141 includes a conductive material layer that is disposed on the semiconductor layer 10 through the first gate insulating film 13.

Moreover, separately from the process of forming the first gate electrode 14 of the first semiconductor element 101, a process of forming the second gate electrode 24 of the second semiconductor element 102 depicted in FIG. 3 is performed on the second active region. More specifically, in accordance with the CVD method or other similar method, a conductive material layer is deposited on the semiconductor layer 10 that is to be used as a region where the second semiconductor element 102 is to be formed. Then, by using the photolithography technique and performing dry etching, a part of the conductive material layer is selectively removed in order to form the second gate electrode 24 of the second semiconductor element 102 in the second active region depicted in FIG. 3. It should be noted that the second gate insulating film 23 of the second semiconductor element 102 may be formed in a process separate from the process for the first gate insulating film 13 of the first semiconductor element 101.

Next, in accordance with the CVD method or other similar method, an extended insulating film is deposited on the semiconductor layer 10 and the horizontal section 141, which are depicted in FIG. 10A. Then, by using the photolithography technique and performing dry etching, a part of the extended insulating film is selectively removed so that the extended insulating film remains on the opposing ends in the gate length direction of the horizontal section 141. The extended insulating film is selectively etched so as to form a half semicircular side wall insulating film 15 on the side wall in the gate length direction of the horizontal section 141, as depicted in FIG. 11.

Next, a photoresist film 43 is applied, and then patterned by using the photolithography technique. Subsequently, as depicted in FIG. 12, impurity ions of the first conductivity type (n type), such as arsenic ions (⁷⁵As⁺) or phosphorus ions (³¹P⁺), are implanted into the opening in the patterned photoresist film 43, in order to form ion-implanted regions 11x and 12x in the upper part of the semiconductor layer 10. As depicted in FIG. 12, the impurity ions of the n type are implanted in the self-aligned manner by using the horizontal section 141 and the side wall insulating film 15 that are exposed from the inside of the opening in the patterned photoresist film 43, as an ion implantation mask. In this instance, the height H1 of the horizontal section 141 is set to be equal to or greater than the depth D1 defined in FIG. 3. Thus, the implanted impurity ions can be prevented from penetrating the horizontal section 141 and reaching the first channel region 10a. Subsequently, the photoresist film 43 is removed.

Further, in order to form the third and fourth main electrode regions 21 and 22 of the second semiconductor element 102, which is depicted in FIG. 3, in the second active region, a new photoresist film is applied and then patterned by using the photolithography technique. Ion implantation is performed by using the patterned photoresist film as an ion implantation mask. In this instance, an acceleration voltage is adjusted so that the projected range of ion implantation is smaller than the projected range D3 of ion implantation for forming the first and second main electrode regions 11 and 12.

It should be noted that the height H1 of the horizontal section 141 may be set to be equal to or greater than the projected range D3 defined in FIG 12 instead of being set to be equal to or greater than the depth D1 of the first and second main electrode regions 11 and 12 that is obtained after thermal diffusion of impurities. The projected range D3 is smaller than the depth D1 of the first and second main electrode regions 11 and 12.

Subsequently, thermal treatment is performed to activate the impurity ions in the ion-implanted regions 11x and 12x, and then the activated impurity elements are thermally diffused in order to form the first and second main electrode regions 11 and 12 as depicted in FIG. 13. The depth D1 of the first and second main electrode regions 11 and 12 is equal to or greater than the depth D0 of the first and second protruding sections 142 and 143 including the thickness of the first gate insulating film 13. Further, the third and fourth main electrode regions 21 and 22 are formed by simultaneously activating the impurity ions in the ion-implanted region of the second semiconductor element 102 and by simultaneously thermally diffusing the activated impurity elements during the above thermal treatment. Subsequently, a well-known metallization process is performed to form, for example, a gate wiring, a source electrode, and a drain electrode. This completes the semiconductor device that includes the first and second semiconductor elements 101, 102 depicted in FIG. 3 as some circuit elements.

According to the method of manufacturing the semiconductor device according to the first embodiment, the first semiconductor element 101 capable of increasing the transconductance gm can be implemented by setting the depth D1 of the first and second main electrode regions 11 and 12 in the first semiconductor element 101 to be equal to or greater than the depth D0 of the first and second protruding sections 142 and 143 including the thickness of the first gate insulating film 13.

Further, the process of forming the first gate electrode 14 of the first semiconductor element 101 and the process of forming the second gate electrode 24 of the second semiconductor element 102 are separately performed. Thus, even in a case where the depth D1 of the first and second main electrode regions 11 and 12 of the first semiconductor element 101 is increased, it is possible to avoid influence on the miniaturization of the second semiconductor element 102.

Moreover, an ion implantation process of forming the first and second main electrode regions 11 and 12 of the first semiconductor element 101 and an ion implantation process of forming the third and fourth main electrode regions 21 and 22 of the second semiconductor element 102 are separately performed. Thus, even in a case where the depth D1 of the first and second main electrode regions 11 and 12 of the first semiconductor element 101 is increased, it is possible to avoid influence on the miniaturization of the second semiconductor element 102.

### <Modification of First Embodiment>

As depicted in FIG. 14, the first semiconductor element 101 included in the semiconductor device according to a modification of the first embodiment differs from the first semiconductor element 101 in the semiconductor device according to the first embodiment depicted in FIG. 3 in that the former has a low-concentration doped drain (LDD) structure. As depicted in FIG. 14, a first extension region 11a is disposed in the upper part of the first main electrode region 11. The first extension region 11a acts as a low-concentration extension region (LDD region). The first extension region 11a has a smaller depth than the first main electrode region 11, and has a lower impurity concentration than the first main electrode region 11. A second extension region 12a is disposed in the upper part of the second main electrode region 12. The second extension region 12a acts as a low-concentration extension region. The second extension region 12a has a smaller depth than the second main electrode region 12, and has a lower impurity concentration than the second main electrode region 12.

As depicted in FIG. 14, the first and second extension regions 11a and 12a are opposed to each other, protrude toward the channel, and overlap with a region below the end of the horizontal section 141. The semiconductor element 101 included in the semiconductor device according to the modification of the first embodiment includes the first and second extension regions 11a and 12a and has a gate overlap structure. This structure is suitable for suppressing the short-channel effects. The other components of the first semiconductor element 101 included in the semiconductor device according to the modification of the first embodiment are similar to those of the first semiconductor element 101 in the semiconductor device according to the first embodiment depicted in FIGS. 3 to 6, and thus will not be redundantly described.

### (Second Embodiment)

### <Semiconductor Device>

As depicted in FIG. 15, the semiconductor element 101 included in the semiconductor device according to a second embodiment includes a first main electrode region 51 and a second main electrode region 52. The first main electrode region 51 and the second main electrode region 52 are disposed in the upper part of the semiconductor layer 10 so as to be opposed to each other through the first channel region 10a. FIG. 15 is equivalent to a cross-sectional view of plane A-A' of FIG. 4, which depicts the first semiconductor element 101 of the semiconductor device according to the first embodiment.

As depicted in FIG. 15, the depth D1 of the first and second main electrode regions 51 and 52 is set to be equal to or greater than the depth D0 of the first and second protruding sections 142 and 143 including the thickness of the first gate insulating film 13 (see FIGS. 5 and 6), as is the case with the first semiconductor element 101 according to the first embodiment. However, the semiconductor element 101 according to the second embodiment differs from the first semiconductor element 101 according to the first embodiment in that the first and second main electrode regions 51 and 52 include a DOPOS formed by a selective CVD method or other vapor deposition method. It should be noted that the first and second main electrode regions 51 and 52 may be vapor-deposited at a relatively high temperature to achieve epitaxial growth. Alternatively, the DOPOS may be thermally treated so as to achieve conversion to crystallinity similar to that of an epitaxial growth layer. Still alternatively, the first and second main electrode regions 51 and 52 may be made to include a highly crystalline epitaxial growth layer by using a photoexcited molecular layer epitaxial growth method in an ultra-high vacuum. The first and second main electrode regions 51 and 52 can also be made substantially monocrystalline by making use of photo-surface catalytic effects of ultraviolet rays during low-pressure CVD.

As is the case with the first semiconductor element 101 according to the first embodiment, the first gate electrode 14 includes the first and second protruding sections 142 and 143, which are embedded in the upper part of the semiconductor layer 10 through the first gate insulating film 13 and positioned parallel to each other, and the horizontal section 141, which is disposed on the semiconductor layer 10 through the first gate insulating film 13 and configured to connect the upper surfaces of the first and second protruding sections 142 and 143 (see, for example, FIGS. 5 and 6). An interlayer insulating film 17 is disposed on the horizontal section 141 of the first gate electrode 14.

The height H1 of the horizontal section 141 may be equal to or greater than the depth D1 of the first and second main electrode regions 51 and 52 or may be the same as the depth D1 of the first and second main electrode regions 51 and 52. The height H1 of the horizontal section 141 in the first gate electrode 14 may be smaller than the depth D1 of the first and second main electrode regions 51 and 52.

The other configurations of the first semiconductor element 101 according to the second embodiment are similar to those of the first semiconductor element 101 according to the first embodiment depicted in FIGS. 3 to 6, and thus will not be redundantly described. Further, the configuration of the second semiconductor element included in the semiconductor device according to the second embodiment is similar to the configuration of the second semiconductor element 102 included in the semiconductor device according to the first embodiment depicted in FIG. 3, and thus will not be redundantly described.

As is the case with the semiconductor device according to the first embodiment, the semiconductor device according to the second embodiment is configured such that the depth D1 of the first and second main electrode regions 51 and 52 in the first semiconductor element 101 is set to be equal to or greater than the depth D0 of the first and second protruding sections 142 and 143 including the thickness of the first gate insulating film 13. This makes it possible to increase the transconductance gm of the first semiconductor element 101.

Further, the first and second main electrode regions 51 and 52 are formed by the selective CVD method or other vapor deposition method. Thus, even when the height H1 of the horizontal section 141 in the first gate electrode 14 is neither equal to nor greater than the depth D1 of the first and second main electrode regions 51 and 52, the impurity ions implanted to form the first and second main electrode regions 51 and 52 in a manufacturing process for the semiconductor device according to the second embodiment can be prevented from penetrating the horizontal section 141 and reaching the first channel region 10a. More specifically, as a doping gas is used to add impurities of a desired conductivity type for vapor deposition purposes, there is no need to perform an ion implantation process for forming the first and second main electrode regions 51 and 52. When the first and second main electrode regions 51 and 52 are of the n type, phosphine (PH₃) or arsine (AsH₃) may be used as the doping gas.

### <Comparative Example>

The semiconductor device according to a comparative example will now be described. As depicted in FIG. 16, the semiconductor element included in the semiconductor device according to the comparative example differs from the first semiconductor element 101 included in the semiconductor device according to the second embodiment depicted in FIG. 15 in that the former includes a first main electrode region 51x and a second main electrode region 52x, which are formed by ion implantation and thermal treatment subsequent to ion implantation. In the semiconductor device according to the comparative example, crystal damage is introduced by ion implantation for forming the first and second main electrode regions 51x and 52x, and then thermal treatment is performed, so that impurities segregate in the semiconductor layer 10 positioned under the first and second main electrode regions 51x and 52x. This gives rise to a dislocation loop or other end-of-range (EOR) defect. Such an EOR defect may cause poor activation of impurities, partially form a high-resistance layer, and increase contact resistance.

In contrast to the semiconductor device according to the comparative example, the first semiconductor element 101 included in the semiconductor device according to the second embodiment is configured such that the first and second main electrode regions 51 and 52 are formed by vapor deposition as depicted in FIG. 15. Thus, there is no EOR defect under the first and second main electrode regions 51 and 52. By using the vapor deposition method, it is possible to suppress an increase in resistance due to an EOR defect and decrease the resistance in the semiconductor layer 10 and the contact resistance. The presence or absence of an EOR defect can be checked by using a transmission electron microscope (TEM).

Further, the semiconductor device according to the second embodiment is configured such that the first and second main electrode regions 51 and 52 are formed by vapor deposition. As the vapor deposition method is used, the impurity ions implanted into the first and second main electrode regions can be prevented from penetrating the horizontal section 141 and reaching the first channel region 10a even if the height H1 of the horizontal section 141 of the first gate electrode 14 is not set to be equal to or greater than the depth D1 of the first and second main electrode regions 51 and 52.

### <Semiconductor Device Manufacturing Method>

Referring to FIGS. 17 to 21, an example of the method of manufacturing the semiconductor device according to the second embodiment will now be described with focus placed on the structure of the first semiconductor element 101 included in the semiconductor device depicted in FIG. 15.

The method of manufacturing the semiconductor device according to the second embodiment is similar to the method of manufacturing the semiconductor device according to the first embodiment in the procedures indicated in FIGS. 10A and 10B. Subsequently, as depicted in FIG. 17, for example, the CVD method and the dry etching method are used to form the interlayer insulating film 17 on the upper surface of the horizontal section 141 and form the side wall insulating film 15 on both end faces in the gate length direction of the horizontal section 141.

Next, in accordance with the CVD method or other similar method, a hard mask insulating film 44 including, for example, an oxide film is deposited as depicted in FIG. 18. Next, a photoresist film 45 is applied to the hard mask insulating film 44, and patterned by using the photolithography technique. The hard mask insulating film 44 is patterned by using the patterned photoresist film 45 as an etching mask, and then a hard mask including the patterned hard mask insulating film 44 is formed as depicted in FIG. 19. Subsequently, the photoresist film 45 is removed.

Next, the hard mask 44, the interlayer insulating film 17, and the side wall insulating film 15 are used as an etching mask to remove a part of the semiconductor layer 10 in the self-aligned manner by performing RIE or other drying etching. As a result, as depicted in FIG. 20, a third trench (first well-shaped groove) 61 and a fourth trench (second well-shaped groove) 62 are formed in the upper part of the semiconductor layer 10. The third trench 61 and the fourth trench 62 are rectangular in shape and disposed to be opposed to each other.

Next, as depicted in FIG. 21, the first main electrode region 51 and the second main electrode region 52 are formed by selectively vapor-growing (vapor-depositing) a silicon layer in each of the third and fourth trenches 61, 62. Subsequently, the hard mask 44 is removed. Depending on growth conditions during vapor deposition, the silicon layer becomes an epitaxial growth layer (monocrystalline layer), a polysilicon layer (polycrystalline layer), or an amorphous layer (non-crystalline layer). As diffusion occurs due to auto-doping during vapor growth, a doped region laterally diffuses to the bottom of the side wall insulating film 15. Subsequently, a well-known metallization process is performed to form, for example, a gate wiring, a source electrode, and a drain electrode. This completes the semiconductor device according to the second embodiment that includes the first semiconductor element 101 depicted in FIG. 15 as some circuit elements.

The method of manufacturing the semiconductor device according to the second embodiment forms the first main electrode region 51 and the second main electrode region 52 by vapor-growing (vapor-depositing) them in the third trench 61 and the fourth trench 62, respectively. Stated differently, the method of manufacturing the semiconductor device according to the second embodiment makes it possible to solve a problem in which the implanted impurity ions penetrate the horizontal section 141 and reach the first channel region 10a in a case where the first and second main electrode regions are formed by ion implantation.

### <Modification of Second Embodiment>

The following describes a method of manufacturing the semiconductor device according to a modification of the second embodiment. This method is used to increase the impurity concentrations of the first and second main electrode regions 51 and 52 in a case where the impurity concentrations of the first and second main electrode regions 51 and 52 are insufficient when a doping gas is used to merely vapor-grow (doping-grow) the first and second first and second main electrode regions 51 and 52.

The method of manufacturing the semiconductor device according to the modification of the second embodiment is similar to the method of manufacturing the semiconductor device according to the second embodiment in the procedure indicated in FIG. 20. Subsequently, for example, a plasma doping method or a solid-phase diffusion method is used to dope first conductivity type (n type) impurities, such as arsenic (As) or phosphorus (P), into the bottom and lateral surfaces of the third and fourth trenches 61 and 62. This results in the formation of first doped regions 51a and 52a of the first conductivity type (n⁺ type), which act as parts of the first and second main electrode regions 51 and 52, as depicted in FIG. 22.

Next, as depicted in FIG. 23, second doped regions 51b and 52b of the first conductivity type (n⁺ type), which act as parts of the first and second main electrode regions 51 and 52, are formed by selectively vapor-growing them in such a manner as to embed a silicon layer in the third and fourth trenches 61 and 62.

Next, as depicted in FIG. 24, the hard mask 44, the interlayer insulating film 17, and the side wall insulating film 15 are used as an ion-implantation mask to implant impurity ions of the first conductivity type (n type), such as arsenic ions (⁷⁵As⁺) or phosphorus ions (³¹P⁺), into the upper surface of the second doped regions 51b and 52b with a small projected range. Subsequently, thermal treatment is performed to activate and thermally diffuse the impurity ions. This results in the formation of third doped regions 51c and 52c of the first conductivity type (n⁺ type), which act as parts of the first and second main electrode regions 51 and 52, as depicted in FIG. 25. Consequently, a first main electrode region (51a, 51b, and 51c) including the first doped region 51a, the second doped region 51b, and the third doped region 51c is formed, and a second main electrode region (52a, 52b, and 52c) including the first doped region 52a, the second doped region 52b, and the third doped region 52c is formed. Subsequently, the hard mask 44 is removed.

The method of manufacturing the semiconductor device according to the modification of the second embodiment forms the first doped regions 51a and 52a, which act as parts of the first and second main electrode regions 51 and 52, by using the plasma doping method or other similar method, before vapor-growing the second doped regions 51b and 52b, which act as parts of the first and second main electrode regions 51 and 52. Thus, as compared to a case where the first and second main electrode regions 51 and 52 are merely vapor-grown, it is possible to increase the impurity concentrations of the first main electrode region (51a, 51b, and 51c) and second main electrode region (52a, 52b, and 52c), particularly the impurity concentrations of the first doped regions 51a and 52a.

Further, the third doped regions 51c and 52c, which act as parts of the first and second main electrode regions 51 and 52, are formed by vapor-growing the second doped regions 51b and 52b, which act as parts of the first and second main electrode regions 51 and 52, then performing shallow ion implantation into the upper surfaces of the second doped regions 51b and 52b, and conducting post-implantation thermal treatment. Thus, as compared to the case where the first and second main electrode regions 51 and 52 are merely vapor-grown, it is possible to increase the impurity concentrations of the first main electrode region (51a, 51b, and 51c) and second main electrode region (52a, 52b, and 52c), particularly the impurity concentrations of the third doped regions 51c and 52c.

It should be noted that the method of manufacturing the semiconductor device according to the modification of the second embodiment has been illustrated with reference to a case where a process of forming the first doped regions 51a and 52a depicted in FIG. 22 and a process of forming the third doped regions 51c and 52c depicted in FIGS. 24 and 25 are both performed. However, an alternative is to perform either the process of forming the first doped regions 51a and 52a depicted in FIG. 22 or the process of forming the third doped regions 51c and 52c depicted in FIGS. 24 and 25, and skip one of these two processes.

### (Other Embodiments)

While the present technology has been described with reference to the first and second embodiments and their modifications, it is to be understood that the present technology is not limited by the statements and drawings included in the present disclosure. It will be obvious from the present disclosure that various alternative embodiments, examples, and operational technologies may be conceived of, by those skilled in the art.

For example, the semiconductor device according to the first or second embodiment is applicable to various types of electronic equipment having an imaging capability, such as a camera system for digital still cameras and video cameras and a mobile phone having an imaging function. For example, the semiconductor device according to the first or second embodiment can be applied to electronic equipment (camera) depicted in FIG. 26. The electronic equipment depicted in FIG. 26 is, for example, a video camera capable of capturing still images or video images, and includes a semiconductor device 200, an optical system (optical lens) 201, a shutter device 202, a signal processing section 203, and a drive section 204 for driving the semiconductor device 200 and the shutter device 202.

The semiconductor device according to the first or second embodiment is applicable as the semiconductor device 200. The optical system 201 receives image light (incident light) from an object, and introduces the received image light into the pixel region 1 of the semiconductor device 200. The optical system 201 may include plural optical lenses. The shutter device 202 controls periods of light irradiation and light shielding with respect to the semiconductor device 200. The drive section 204 controls a transfer operation of the semiconductor device 200 and a shutter operation of the shutter device 202. The signal processing section 203 performs various signal processes on signals outputted from the semiconductor device 200. Signal-processed video signals are either stored in a storage medium, such as a memory, or outputted, for example, to a monitor.

Further, the semiconductor device according to the first or second embodiment has been illustrated with reference to a case where the first semiconductor element 101 is an amplifying transistor. However, the first semiconductor element 101 may alternatively be a pixel transistor, such as a transfer transistor, instead of being an amplifying transistor. Further, the first semiconductor element 101 is not only applicable as a pixel transistor, but also applicable as an analog transistor in a peripheral circuit. In a case where the first semiconductor element 101 is an analog transistor in a peripheral circuit, an s factor (s value) can be reduced by setting the depth D1 of the first and second main electrode regions 51 and 52 to be equal to or greater than the depth D0 of the first and second protruding sections 142 and 143 including the thickness of the first gate insulating film 13.

Moreover, the semiconductor device according to the first or second embodiment has been illustrated with reference to a case where the semiconductor layer 10 is a Si substrate. However, the Si substrate may be substituted by a semiconductor (wide-bandgap semiconductor) substrate having a wider band gap than Si, such as silicon carbide (SiC), gallium nitride (GaN), or gallium arsenide (GaAs).

When the technical content disclosed by the foregoing embodiments is understood as described above, it will be obvious to those skilled in the art that various alternative embodiments, examples, and operational technologies can be included in the present technology. Further, it is apparent that the present technology also includes, for example, configurations formed as appropriate by using individual components described in conjunction with the foregoing embodiments and modifications and various embodiments other than those described in this document. Therefore, the technical scope of the present technology is defined only by matters specifying the claimed invention that are appropriate based on the above illustrative explanation.

It should be noted that the present technology may adopt the following configurations.
(1) A semiconductor element including:
   a semiconductor layer;
   a channel region that is disposed in an upper part of the semiconductor layer;
   first and second main electrode regions that are opposed to each other and disposed on opposing ends in a channel length direction of the channel region;
   a gate insulating film that is disposed on inner walls of first and second trenches and on an upper surface of the channel region, the first and second trenches being disposed on both lateral surfaces that are opposed to each other in a channel width direction of the channel region; and
   a gate electrode that includes a first protruding section, a second protruding section, and a horizontal section, the first protruding section being embedded in the first trench through the gate insulating film, the second protruding section being embedded in the second trench through the gate insulating film, the horizontal section being connected to upper ends of the first and second protruding sections and disposed on the upper surface of the channel region through the gate insulating film,
   in which a depth of the first and second main electrode regions is equal to a depth of the first and second protruding sections including the gate insulating film.
(2) The semiconductor element according to (1), in which a height of the horizontal section is equal to or greater than the depth of the first and second main electrode regions.
(3) The semiconductor element according to (1) or (2), in which the semiconductor layer positioned underneath the first and second main electrode regions has no end-of-range defects.
(4) A semiconductor device including:
   a first semiconductor element that includes a semiconductor layer, a channel region, first and second main electrode regions, a gate insulating film, and a gate electrode, the channel region being disposed in an upper part of the semiconductor layer, the first and second main electrode regions being opposed to each other and disposed on opposing ends in a channel length direction of the channel region, the gate insulating film being disposed on inner walls of first and second trenches and on an upper surface of the channel region, the first and second trenches being disposed on both lateral surfaces that are opposed each other in a channel width direction of the channel region, the gate electrode including a first protruding section, a second protruding section, and a horizontal section, the first protruding section being embedded in the first trench through the gate insulating film, the second protruding section being embedded in the second trench through the gate insulating film, the horizontal section being connected to upper ends of the first and second protruding sections and disposed on the upper surface of the channel region through the gate insulating film; and
   a second semiconductor element that includes third and fourth main electrode regions and a second gate electrode, the third and fourth main electrode regions being opposed to each other and disposed in the upper part of the semiconductor layer, the second gate electrode being disposed on the semiconductor layer sandwiched between the third and fourth main electrode regions through a second gate insulating film,
   in which a depth of the first and second main electrode regions is equal to a depth of the first and second protruding sections including the gate insulating film.
(5) The semiconductor device according to (4), in which a depth of the third and fourth main electrode regions is smaller than the depth of the first and second main electrode regions.
(6) The semiconductor device according to (4) or (5), in which a height of the second gate electrode is smaller than a height of the horizontal section.
(7) The semiconductor device according to any one of (4) to (6),
   in which the first semiconductor element includes an amplifying transistor included in a pixel of a solid-state imaging device, and
   the second semiconductor element includes a transistor included in a peripheral circuit of the solid-state imaging device.
(8) A semiconductor element manufacturing method including steps of:
   digging a recessed section in an upper part of a semiconductor layer so as to form a channel region demarcated by the recessed section;
   embedding an element separation insulating film in the recessed section;
   selectively removing the element separation insulating film and digging first and second trenches so as to expose lateral surfaces that are opposed to each other in a channel width direction of the channel region;
   forming a gate insulating film on inner walls of the first and second trenches and on an upper surface of the channel region;
   embedding a conductive material layer in the first and second trenches through the gate insulating film and forming a gate electrode including a first protruding section, a second protruding section, and a horizontal section, the first protruding section being embedded in the first trench, the second protruding section being embedded in the second trench, the horizontal section being connected to upper ends of the first and second protruding sections and disposed on the upper surface of the channel region through the gate insulating film; and
   forming first and second main electrode regions that are opposed to each other across opposing ends in a channel length direction of the channel region in the same depth as the first and second protruding sections including the gate insulating film.
(9) The semiconductor element manufacturing method according to (8),
   in which the step of forming the first and second main electrode regions includes
      a process of implanting impurity ions into an upper surface of the semiconductor layer, and
      a process of activating the impurity ions by performing thermal treatment, and
   a thickness of the horizontal section is greater than a projected range of the impurity ions.
(10) The semiconductor element manufacturing method according to (8),
   in which the step of forming the first and second main electrode regions includes
   a process of digging third and fourth trenches that are opposed to each other and disposed on the opposing ends in the channel length direction of the channel region, and
   a process of forming the first and second main electrode regions by embedding a conductive material layer in the third and fourth trenches in accordance with a vapor deposition method.
(11) The semiconductor element manufacturing method according to (10), further including:
   before the process of embedding according to the vapor deposition method, a process of adding impurities of the same conductivity type as the first and second main electrode regions to bottom and lateral surfaces of the third and fourth trenches by using thermal diffusion.
(12) The semiconductor element manufacturing method according to (10) or (11), further including:
   after the process of embedding according to the vapor deposition method,
   a process of implanting impurity ions of the same conductivity type as the first and second main electrode regions into upper surfaces of the first and second main electrode regions; and
   a process of activating the impurity ions by performing thermal treatment.
(13) A semiconductor device manufacturing method including steps of:
   digging a recessed section in an upper part of a semiconductor layer so as to form a channel region demarcated by the recessed section;
   embedding an element separation insulating film in the recessed section;
   selectively removing the element separation insulating film and digging first and second trenches so as to expose lateral surfaces that are opposed to each other in a channel width direction of the channel region;
   forming a gate insulating film on inner walls of the first and second trenches and on an upper surface of the channel region;
   embedding a conductive material layer in the first and second trenches through the gate insulating film and forming a gate electrode including a first protruding section, a second protruding section, and a horizontal section, the first protruding section being embedded in the first trench, the second protruding section being embedded in the second trench, the horizontal section being connected to upper ends of the first and second protruding sections and disposed on the upper surface of the channel region through the gate insulating film;
   forming first and second main electrode regions that are opposed to each other across opposing ends in a channel length direction of the channel region in the same depth as the first and second protruding sections including the gate insulating film;
   forming a second gate electrode on the semiconductor layer through the gate insulating film; and
   forming third and fourth main electrode regions that are opposed to each other across the semiconductor layer below the second gate electrode in a depth different from that of the first and second main electrode regions.

### [Reference Signs List]

- 1:: Pixel region
- 2:: Pixel
- 3:: Vertical drive circuit
- 4:: Column signal processing circuit
- 5:: Horizontal drive circuit
- 6:: Output circuit
- 7:: Control circuit
- 8a:: Pixel drive wiring
- 8b:: Vertical signal line
- 9:: Horizontal signal line
- 10:: Semiconductor layer
- 10a:: Channel region
- 10b:: Well region
- 11, 12:: Main electrode region
- 11a, 12a:: Extension region
- 11x, 12x:: Ion-implanted region
- 13:: Gate insulating film
- 14:: Gate electrode
- 15:: Side wall insulating film
- 16:: Element separation insulating film
- 17:: Interlayer insulating film
- 21, 22:: Main electrode region
- 23:: Gate insulating film
- 24:: Gate electrode
- 30:: Recessed section
- 31, 32:: Trench
- 41, 42:: Etching protective film
- 43, 45:: Photoresist film
- 44:: Hard mask
- 51, 51x, 52, 52x:: Main electrode region
- 51a, 51b, 51c, 52a, 52b, 52c:: Doped region
- 61, 62:: Trench
- 101, 102:: Semiconductor element
- 141:: Horizontal section
- 142, 143:: Protruding section
- 200:: Semiconductor device
- 201:: Optical system
- 202:: Shutter device
- 203:: Signal processing section
- 204:: Drive section

## Claims

1. A semiconductor element comprising:
a semiconductor layer;
a channel region that is disposed in an upper part of the semiconductor layer;
first and second main electrode regions that are opposed to each other and disposed on opposing ends in a channel length direction of the channel region;
a gate insulating film that is disposed on inner walls of first and second trenches and on an upper surface of the channel region, the first and second trenches being disposed on both lateral surfaces that are opposed to each other in a channel width direction of the channel region; and
a gate electrode that includes a first protruding section, a second protruding section, and a horizontal section, the first protruding section being embedded in the first trench through the gate insulating film, the second protruding section being embedded in the second trench through the gate insulating film, the horizontal section being connected to upper ends of the first and second protruding sections and disposed on the upper surface of the channel region through the gate insulating film,
wherein a depth of the first and second main electrode regions is equal to a depth of the first and second protruding sections including the gate insulating film.

2. The semiconductor element according to claim 1, wherein a height of the horizontal section is equal to or greater than the depth of the first and second main electrode regions.

3. The semiconductor element according to claim 1, wherein the semiconductor layer positioned underneath the first and second main electrode regions has no end-of-range defects.

4. A semiconductor device comprising:
a first semiconductor element that includes a semiconductor layer, a channel region, first and second main electrode regions, a gate insulating film, and a gate electrode, the channel region being disposed in an upper part of the semiconductor layer, the first and second main electrode regions being opposed to each other and disposed on opposing ends in a channel length direction of the channel region, the gate insulating film being disposed on inner walls of first and second trenches and on an upper surface of the channel region, the first and second trenches being disposed on both lateral surfaces that are opposed each other in a channel width direction of the channel region, the gate electrode including a first protruding section, a second protruding section, and a horizontal section, the first protruding section being embedded in the first trench through the gate insulating film, the second protruding section being embedded in the second trench through the gate insulating film, the horizontal section being connected to upper ends of the first and second protruding sections and disposed on the upper surface of the channel region through the gate insulating film; and
a second semiconductor element that includes third and fourth main electrode regions and a second gate electrode, the third and fourth main electrode regions being opposed to each other and disposed in the upper part of the semiconductor layer, the second gate electrode being disposed on the semiconductor layer sandwiched between the third and fourth main electrode regions through a second gate insulating film,
wherein a depth of the first and second main electrode regions is equal to a depth of the first and second protruding sections including the gate insulating film.

5. The semiconductor device according to claim 4, wherein a depth of the third and fourth main electrode regions is smaller than the depth of the first and second main electrode regions.

6. The semiconductor device according to claim 4, wherein a height of the second gate electrode is smaller than a height of the horizontal section.

7. The semiconductor device according to claim 4,
wherein the first semiconductor element includes an amplifying transistor included in a pixel of a solid-state imaging device, and
the second semiconductor element includes a transistor included in a peripheral circuit of the solid-state imaging device.

8. A semiconductor element manufacturing method comprising steps of:
digging a recessed section in an upper part of a semiconductor layer so as to form a channel region demarcated by the recessed section;
embedding an element separation insulating film in the recessed section;
selectively removing the element separation insulating film and digging first and second trenches so as to expose lateral surfaces that are opposed to each other in a channel width direction of the channel region;
forming a gate insulating film on inner walls of the first and second trenches and on an upper surface of the channel region;
embedding a conductive material layer in the first and second trenches through the gate insulating film and forming a gate electrode including a first protruding section, a second protruding section, and a horizontal section, the first protruding section being embedded in the first trench, the second protruding section being embedded in the second trench, the horizontal section being connected to upper ends of the first and second protruding sections and disposed on the upper surface of the channel region through the gate insulating film; and
forming first and second main electrode regions that are opposed to each other across opposing ends in a channel length direction of the channel region in a same depth as the first and second protruding sections including the gate insulating film.

9. The semiconductor element manufacturing method according to claim 8,
wherein the step of forming the first and second main electrode regions includes
a process of implanting impurity ions into an upper surface of the semiconductor layer, and
a process of activating the impurity ions by performing thermal treatment, and
a thickness of the horizontal section is greater than a projected range of the impurity ions.

10. The semiconductor element manufacturing method according to claim 8,
wherein the step of forming the first and second main electrode regions includes
a process of digging third and fourth trenches that are opposed to each other and disposed on the opposing ends in the channel length direction of the channel region, and
a process of forming the first and second main electrode regions by embedding a conductive material layer in the third and fourth trenches in accordance with a vapor deposition method.

11. The semiconductor element manufacturing method according to claim 10, further comprising:
before the process of embedding according to the vapor deposition method, a process of adding impurities of a same conductivity type as the first and second main electrode regions to bottom and lateral surfaces of the third and fourth trenches by using thermal diffusion.

12. The semiconductor element manufacturing method according to claim 10, further comprising:
after the process of embedding according to the vapor deposition method,
a process of implanting impurity ions of a same conductivity type as the first and second main electrode regions into upper surfaces of the first and second main electrode regions; and
a process of activating the impurity ions by performing thermal treatment.

13. A semiconductor device manufacturing method comprising steps of:
digging a recessed section in an upper part of a semiconductor layer so as to form a channel region demarcated by the recessed section;
embedding an element separation insulating film in the recessed section;
selectively removing the element separation insulating film and digging first and second trenches so as to expose lateral surfaces that are opposed to each other in a channel width direction of the channel region;
forming a gate insulating film on inner walls of the first and second trenches and on an upper surface of the channel region;
embedding a conductive material layer in the first and second trenches through the gate insulating film and forming a gate electrode including a first protruding section, a second protruding section, and a horizontal section, the first protruding section being embedded in the first trench, the second protruding section being embedded in the second trench, the horizontal section being connected to upper ends of the first and second protruding sections and disposed on the upper surface of the channel region through the gate insulating film;
forming first and second main electrode regions that are opposed to each other across opposing ends in a channel length direction of the channel region in a same depth as the first and second protruding sections including the gate insulating film;
forming a second gate electrode on the semiconductor layer through the gate insulating film; and
forming third and fourth main electrode regions that are opposed to each other across the semiconductor layer below the second gate electrode in a depth different from that of the first and second main electrode regions.
